# EUROPÄISCHE PATENTSCHRIFT

(11) **EP 0 593 806 B1**
(45) Veröffentlichungstag und Bekanntmachung des Hinweises auf die Patenterteilung: **17.04.2002**
(21) Anmeldenummer: 92118032.9
(22) Anmeldetag: 21.10.1992
(51) Int. Cl.: G03F 7/12, G03F 7/20, B41C 1/14, B41N 1/24, B23K 26/08

(54) **Verfahren zur Herstellung einer Siebdruckschablone**
Method for the preparation of a screen mesh for screen printing
Procédé pour la fabrication d'un écran de sérigraphie

(43) Veröffentlichungstag der Anmeldung: 27.04.1994
(60) Teilanmeldung: 94115973.3
(73) Patentinhaber: Schablonentechnik Kufstein Aktiengesellschaft, 6330 Kufstein (AT)
(72) Erfinder: Fischer, Hans, Ing., A-6300 Wörgl (AT)
(74) Vertreter: TER MEER STEINMEISTER & PARTNER GbR

(56) Entgegenhaltungen:
- EP-A- 0 291 137
- EP-A- 0 338 612
- EP-A- 0 491 368
- WO-A-86/04549
- DE-A- 2 359 088
- DE-A- 4 142 887
- FR-A- 2 158 869
- FR-A- 2 320 834
- US-A- 4 705 608
- PATENT ABSTRACTS OF JAPAN vol. 016, no. 348 (P-1393)28. Juli 1992
- MAKROMOLEKULARE CHEMIE, MACROMOLECULAR CHEMISTRY AND PHYSICS Bd. 181, Nr. 6, Juni 1980, BASEL CH Seiten 1307 - 1319 MERLIN ET AL. 'Mechanism of the Methyl Methacrylate Polymerization Photo-induced by Benzoin Derivates'
- MAKROMOLEKULARE CHEMIE, MACROMOLECULAR CHEMISTRY AND PHYSICS Bd. 191, Nr. 4, April 1990, BASEL CH Seiten 963 - 979 DECKER ET AL. 'Kinetic investigation of photopolymerizations induced by laser beams'
- A. REISER: "Photoreactive Polymers: the science and technology of resists", 1989, JOHN WILEY & SONS, NEW YORK

## Beschreibung

Die Erfindung betrifft ein Verfahren zur Herstellung einer Siebdruckschablone, insbesondere zum Bedrucken von Textilien.

Es ist bereits vorgeschlagen worden, zur Herstellung einer Siebdruckschablone ein hohlzylindrisches Rundsieb mit einem photoempfindlichen Lack (Photolack) zu beschichten und dann unter Verwendung eines Ganzfilmes, das ist ein die ganze Oberfläche der Siebdruckschablone abdeckender Film, zu belichten, um auf diese Weise die photoempfindliche Lackschicht an den belichteten Stellen zu vernetzen bzw. zu polymerisieren. Dabei wird durch Absorption eines Lichtquantes ein Polymerisationsprozeß zumindest eingeleitet.

Nachteilig an diesem Verfahren ist die Notwendigkeit der Herstellung eines Ganzfilmes, der eine Größe von ca. 2 m² aufweist. Ferner muß die Oberfläche der photoempfindlichen Lackschicht völlig trocken sein, da sonst der Film mit der Lackschicht verklebt. Hierdurch wird die Möglichkeit, aus oft sehr reaktiven Photolacken auswählen zu können, erheblich eingeschränkt, da viele von ihnen nicht vollständig austrocknen. Schließlich hat bei Rundsieben der Film eine Nahtstelle, die bei komplizierten Mustern aufwendig retuschiert werden muß.

Aus Patent Abstracts of Japan, Vol. 016, No. 348 (P-1393) & JP-A-04/106547 ist bereits ein Verfahren zur Herstellung einer Siebdruckschablone bekannt, bei dem auf der Zylinderoberfläche eines Rotationszylinders eine Siebdruckplatte aufgebracht wird, die mit einer photoempfindlichen Lackschicht beschichtet ist. Diese photoempfindliche Lackschicht wird bei Drehung des zylindrischen Trägers ortsselektiv mittels eines Argon-Lasers belichtet, um die belichteten Stellen der Lackschicht auszuhärten. Anschließend wird die so belichtete Lackschicht entwickelt. Bei der Lackschicht handelt es sich um eine Photopolymerschicht, die mit einem Monomer versehen ist.

Aus der US 4 705 608, die sich mit einem Verfahren zur Herstellung eines Siebdruckgewebes für Siebdruckzylinder beschäftigt, ist es bekannt, daß es selbst bei Benutzung von thixotropen Emulsionen nicht möglich ist, bei der Beschichtung von Siebdruckgeweben eine glatte Oberflächenbeschichtung zu erhalten, da, falls die Thixotropizität zu gering ist, die Emulsion in das Sieb eindringt und da, falls die Thixotropizität zu hoch ist, eine zufriedenstellende Entgasung des Gewebes nicht möglich ist.

Darüber hinaus ist es aus C. Decker und K. Moussa: Kinetic investigations of photopolymerizations induced by laser beams. In: Macromolecular Chemistry and Physics 191, 963-979 (1990) bekannt, zum Zwecke der Herstellung von Druckplatten Schichten aus photopolymerisierbarem Harz, versetzt mit einem Monomer, mit Hilfe von UV-Lasern zu belichten und zu härten.

Nicht zuletzt ist es aus der EP-A-0 338 612 bekannt, zylindrische Metallsiebe mit einer photoempfindlichen Beschichtung zu versehen und diese zu trocknen.

Bei der Durchführung photolithographischer Verfahren, insbesondere bei der Mikrolithographie ist es bekannt, die auf ein Substrat aufgetragene Photoresistschicht, also eine photoempfindliche Beschichtung, nachdem sie lufttrocken ist, einer Wärmebehandlung in einem Ofen mit einem intensiven Luftstrom zu unterziehen, um die letzten Reste von Lösungsmitteln aus der Photoresistschicht zu entfernen und mechanische Spannungen in der Beschichtung zu beseitigen.

Das erfindungsgemäße Verfahren zur Herstellung einer Siebdruckschablone, insbesondere zum Bedrucken von Textilien, umfaßt folgende Schritte: Bildung eines hohlzylindrischen Rundsiebs; Auftragen einer photoempfindlichen Lackschicht auf die äußere Oberfläche des Rundsiebs, die durch geeignete Additive bzw. Füllstoffe thixotrop eingestellt ist, so daß die noch unvernetzte Lackschicht nicht abschließen kann; die schon während des Beschichtungsvorgangs luftvorgetrocknete Schablone wird in einem Warmluftofen nachgetrocknet, so daß keine Lösungsmittelreste mehr in der Lackschicht verbleiben; ortsselektives Belichten der Lackschicht mittels einer Lasereinrichtung zwecks Vernetzung und Aushärtung der belichteten Stellen der Lackschicht unter Drehung des Rundsiebs; und Entwickeln der so belichteten Lackschicht.

Mit Hilfe des erfindungsgemäßen Verfahrens lassen sich sowohl Rundschablonen als auch Flachschablonen herstellen. Zur Herstellung von Rundschablonen werden Rundsiebe verwendet, bei denen es sich um kreisförmige Drahtgewegezylinder oder galvanoplastisch hergestellte, sehr dünnwandige perforierte Hohlzylinder handelt. Flachsiebe sind ebene Siebe, die in einen Rahmen gespannt werden. Damit sie erfindungsgemäß strukturiert werden können, werden sie zur Bildung eines Rundsiebes auf ein dünnes, kreisrundes Hohlprofilrohr aufgelegt und anschließend entsprechend bearbeitet.

Das Auftragen der photoempfindlichen Lackschicht kann mittels einer Ringrakel erfolgen, die in Axialrichtung über das Rundsieb gezogen wird. Die photoempfindliche Lackschicht kann aber auch durch Aufsprühen von Lack mittels einer Zerstäuberdüse unter Drehung des Rundsiebes aufgebracht werden, wozu das Rundsieb in eine Rotationsvorrichtung eingespannt wird, in dessen Axialrichtung die Zerstäuberdüse bewegt wird.

Bei der Erfindung kann zur Bildung der photoempfindlichen Lackschicht ein einen Photoinitiator enthaltendes Momomer aufgetragen werden. Soll die photoempfindliche Lackschicht mit Laserstahlung einer gewünschten Wellenlänge belichtet werden, so müssen ihre Eigenschaften so gewählt werden, daß bei dieser Wellenlänge ein Polymerisationsprozeß gestartet werden kann. Besondere Wirksamkeit haben in diesem Zusammenhang die Photoinitiatoren, die für eine optimale Wirkungsweise ein auf die Bestrahlungsquelle abgestimmtes Absorptionsverhalten und damit verbunden eine hohe Lichtempfindlichkeit aufweisen müssen, und die in möglichst geringen Einsatzkonzentrationen vorhanden sein sollten, um gewünschte physikalische Eigenschaften der photoempfindlichen Lackschicht wie Haftvermögen auf der Sieboberfläche, Verschleißfestigkeit, und dergleichen, nicht zu verschlechtern. Diese Photoinitiatoren initiieren den Polymerisationsprozeß, der, einmal in Gang gesetzt, von selbst weiterläuft, oder sie wirken in der Art eines Katalysators. Die genannten Eigenschaften können aber auch durch die gewählten Monomere beeinflußt werden, wobei insbesondere auch Wert auf die Chemikalienbeständigkeit zu legen ist.

Nach der Erfindung kann ein Monomer zum Einsatz kommen, das Urethan Diacrylate und/oder Methacrylate enthält. Hierdurch lassen sich besonders gute Eigenschaften der photoempfindlichen Lackschicht im Hinblick auf das Haftvermögen, die Verschleißfestigkeit und die Chemikalienbeständigkeit erzielen.

Soll die photoempfindliche Lackschicht mit UV-Strahlung belichtet werden, so werden besonders gute Ergebnisse hinsichtlich der Lichtempfindlichkeit erzielt, wenn dem o. g. Monomer folgende Photoinitiatoren einzeln oder in Kombination zugesetzt werden:
1. 1 bis 4 Gew. % an
   2-Benzyl-2-Dimethylamino-1-(4-Morpholinophenyl)-Butanone-1, ggf. gemischt mit 1 bis 3 Gew. % an 1-Hydroxy-Cyclohexyl-Phenyl-Keton;
2. 2-Hydroxy-2-Methyl-1-Phenyl-Propan-1-one;
3. Mischung aus 1-Hydroxy-Cyclohexyl-Phenyl-Keton und Benzophenon;
4. 2-Methyl-1-(4-(Methylthio)Phenyl)-2-Morpholinopropanone-1;
5. 2,2-Dimethoxy-1,2-Diphenylethan-1-one.

Als ein weiteres besonders geeignetes Polymersystem wird Polyphtalaldehyd mit einem Aryloniumsalz als Photoinitiator genannt.

Die o. e. photoempfindlichen Lackschichten weisen insbesondere im UV-Bereich zwischen 200 nm bis 450 nm eine für die genannten Zwecke ausreichende Lichtempfindlichkeit auf. So konnten Schichten der genannten Art mit einer Dicke von 10 bis 20 µm bei einer Laserausgangsleistung von 1,5 mJoule/cm² und bei einer Laserwellenlänge von 350 nm hinreichend belichtet werden.

Nach dem erfindungsgemäßen Verfahren wird die Lackschicht vor dem Belichten getrocknet. Hierzu kann das Rundsieb zum Trocknen der Lackschicht mit seiner Längsachse vertikal aufgestellt oder in eine Rotationsvorrichtung eingespannt werden, so daß das Rundsieb beim Trocknen der Lackschicht horizontal liegt und um seine Längsachse gedreht werden kann.

Die Haftung der photoempfindlichen Lackschicht am metallischen Untergrund wird durch höhere Temperaturen verbessert, allerdings besteht dabei auch die Gefahr, daß sich das optische Auflösungsvermögen verringert. Das Trocknen der Lackschicht erfolgt daher vorzugsweise beiTemperaturen im Bereich von 60 bis 150°C, so daß ein optimaler Kompromiß zwischen Haftfähigkeit und Auflösungsvermögen erzielt wird.

Zur Entwicklung der belichteten Lackschicht wird vorzugsweise eine alkalische Lösung verwendet, beispielsweise eine Sodalösung, Kalilauge oder Natronlauge. Unverbrauchte Entwicklerlösung kann z. B. auf die Schablone aufgesprüht werden, während diese zum Teil in ein Entwicklerbad eintaucht und gedreht wird.

Nach einer Weiterbildung der Erfindung kann das Rundsieb in eine Rotationsvorrichtung eingespannt werden, wobei die Lackschicht anschließend unter Drehung des Rundsiebes in aufeinanderfolgenden Schritten aufgebracht, getrocknet, belichtet und entwickelt wird. Sämtliche Arbeitsvorgänge lassen sich somit bei in der Rotationsvorrichtung eingespanntem Rundsieb durchführen, ohne daß es zwischen den einzelnenArbeitsschritten von Bearbeitungsstation zu Bearbeitungsstation transportiert werden muß. Schablonen der genannten Art lassen sich daher besonders schnell und auch ohne größere Beschädigungsgefahr herstellen, so daß sich die Ausschußrate erheblich senken läßt.

Die Erfindung wird nachfolgend unter Bezugnahme auf die Zeichnung näher beschrieben. Es zeigen:
**Fig. 1** einen Verfahrensschritt zur Beschichtung eines hohlzylindrischen Rundsiebes mit einer photoempfindlichen Lackschicht,
**Fig. 2** einen entsprechenden Verfahrensschritt, bei dem jedoch die photoempfindliche Lackschicht auf das Rundsieb aufgesprüht wird,
**Fig. 3** eine Belichtungsvorrichtung zur Belichtung der photoempfindlichen Lackschicht,
**Fig. 4** eine Seitenansicht der Belichtungsvorrichtung nach Fig. 3,
**Fig. 5** eine weitere Belichtungsvorrichtung zur Belichtung der photoempfindlichen Lackschicht,
**Fig. 6** eine Seitenansicht der weiteren Belichtungsvorrichtung nach Fig. 5, und
**Fig. 7** einen Verfahrensschritt zur Entwicklung der belichteten photoempfindlichen Lackschicht.

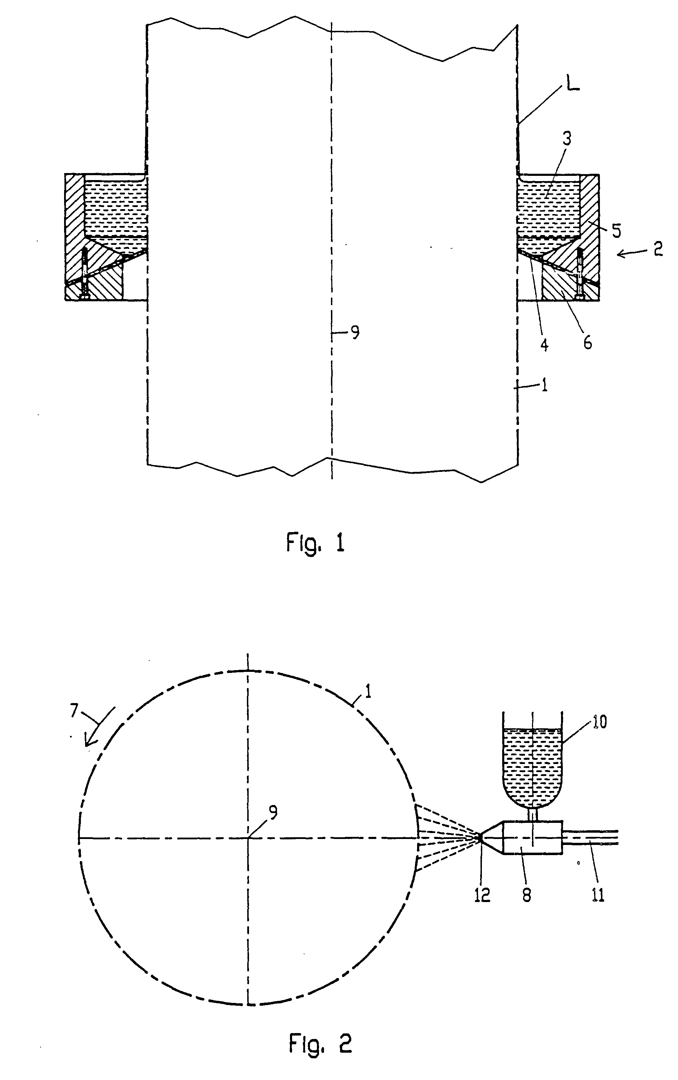

Nachfolgend wird die Erfindung unter Bezugnahme auf die Figuren 1 bis 7 im einzelnen beschrieben.

In der Figur 1 ist ein Rundsieb 1 gezeigt, welches unter Verwendung einer Ringrakel 2 mit einem flüssigen Photopolymer beschichtet wird. Das flüssige Photopolymer befindet sich in einer kreisringförmigen Wanne 3 und kann dank einer dichtend an dem Rundsieb 1 anliegenden Gummilippe 4 nicht aus der Wanne 3 herausfließen. Die Gummilippe 4 wird zwischen einem Ringrakeloberteil 5 und einem Ringrakelunterteil 6 gehalten. Das Photopolymer weist etwa eine Viskosität eines zähen Motoröls auf und kann zufolge einer nach abwärts gerichteten Bewegung der Ringrakel 2 nicht durch das Rundsieb 1 in dessen Innenraum fließen. Der Grund liegt darin, daß der statische Druck, unter dem das zähflüssige Photopolymer steht, nur dem Stand der Flüssigkeitshöhe in der Wanne 3 der Ringrakel 2 entspricht und daher sehr gering ist. Auch kommt dieser statische Druck auf einen Längenabschnitt des Rundsiebes 1 nur ganz kurze Zeit zur Wirkung, und zwar so lange, als die Ringrakel 2 aufgrund ihrer nach abwärts gerichteten Geschwindigkeit benötigt, um die Höhe des Flüssigkeitsstands in der Wanne 3 zu durchlaufen.

Das Rundsieb 1 ist so engmaschig bzw. weist so kleine Bohrungen auf, daß der geringe statische Druck zwar ausreicht, das Polymer innerhalb der verfügbaren Zeit in die Bohrungen zu drücken und diese aufzufüllen, nicht aber reicht dieser Druck aus, um die sich gegen das Innere des Rundsiebes 1 in jeder kleinen kapilaren Bohrung ausbildende Flüssigkeitsmembran zu überdrücken und so aufzureißen. Dadurch ist ein Austritt von Photopolymer in das Innere des Rundsiebes 1 auch bei Verringerung derAbsenkgeschwindigkeit der Ringrakel 2 weitgehend unmöglich.

Die Absenkgeschwindigkeit der Ringrakel 2 wird so gewählt, daß die auf dem Rundsieb 1 verbleibende Polymerschicht die gewünschte Dicke aufweist. Die Dicke der Photopolymerschicht wird dabei größer, wenn die Ringrakel 2 schnell abgesenkt wird, während die Dicke geringer wird, je langsamer die Abwärtsbewegung der Ringrakel 2 gewählt wird. Dies ist verständlich, wenn man bedenkt, daß das Photopolymer eine Lösung von (lichtempfindlichen) Harzen in einem leicht abdampfenden Lösungsmittel ist. Das aus der Wanne 3 herausgezogene Rundsieb 1 reißt einen entsprechend dicken Flüssigkeitsfilm mit sich. Die innerste Schicht dieses Flüssigkeitsfilms haftet an dem Rundsieb 1, während die äußeren Schichten des Flüssigkeitsfilms infolge ihres Gewichts nach abwärts in die Wanne 3 zurückfließen. Dabei fließen die äußersten Schichten am schnellsten zurück.

Während dieses Vorgangs dampft das Lösungsmittel ab. Je dünner die Flüssigkeitsschicht geworden ist, desto stärker sind die spezifischen Lösungsmittelverluste der verbleibenden Schicht und damit deren Viskositätssteigerung, da die Menge des abdampfenden Lösungsmittels pro Zeiteinheit nur von der Umgebungstemperatur und der Oberfläche abhängt und damit im wesentlichen konstant bleibt.

Schließlich wird eine so hohe Viskosität erreicht, daß die Geschwindigkeit der äußersten und nach unten abfließenden Schichten der Absenkgeschwindigkeit entspricht und somit das Photopolymer nicht mehr die Wanne 3 erreichen kann. Dieser Beschichtungsvorgang ergibt daher auch dann noch gleichmäßige Dicken der Photopolymerschicht, wenn das Rundsieb 1 keine genaue kreiszylindrische Oberfläche aufweist, sondern z. B. leicht verbeult ist.

Alternativ kann aber auch eine Beschichtung des Rundsiebes 1, wenn es gemäß Figur 2 in Richtung des Pfeils 7 gedreht wird, mittels einer Zerstäuberdüse 8 erfolgen. Dabei wird die Zerstäuberdüse 8 in Richtung der Längsachse 9 des Rundsiebes 1 bewegt. Das Photopolymer, welches sich in einem Becher 10 oberhalb der Zerstäuberdüse 8 befindet, wird durch eine injectorartige Vorrichtung im Innern der Zerstäuberdüse 8 aus dem Becher 10 angesaugt und mit der den Injector betreibenden Druckluft, die durch einen Schlauch 11 1 zugeführt wird, durch ein Mundstück 12 der Zerstäuberdüse 8 ausgestoßen und dort nach an sich bekannter Weise zerstäubt. Dies wird z. B. durch einen unter mehr als 2 bar Überdruck stehenden Luftstrahl erreicht, in welchem intensive Ultraschallwellen auftreten, durch die das Photopolymer in kleinste Flüssigkeitsteilchen zerrissen wird. Dank der Drehbewegung des Rundsiebes 1 und der gleichzeitig erfolgenden Vorschubbewegung der Zerstäuberdüse 8 in axialer Richtung des Rundsiebes 1 wird der Photopolymernebel gleichmäßig auf der Oberfläche des Rundsiebes 1 verteilt.

Wie bereits eingangs erwähnt, kann anstelle eines Rundiebes 1 auch ein Flachsieb verwendet werden, welches auf ein kreiszylindrisches Trägerrohr z. B. mittels Klebebändern aufgespannt wird.

Eine insbesondere für die Ultraviolett(UV)-Laserbestrahlung geeignete photoempfindliche Lackschicht (Harzsystem) enthält folgende Komponenten:

### Monomer:

Urethan Diacrylate und Methacrylate;

### Photoinitiator:

1 % bis 4 %
2-Benzyl-2-Dimethylamino-1-(4-Morpholinophenyl)-Butanone-1
ggf. gemischt mit
1 % bis 3 %
1-Hydroxy-Cyclohexal-Phenyl-Keton

Ferner sind als Photoinitiatoren geeignet:
1) 2-Hydroxy-2-Methyl-1-Phenyl-Propan-1-one
2) Mischung aus:
   1-Hydroxy-Cyclohexyl-Phenyl-Keton
   Benzophenon
3) 2-Methyl-1-(4-(Methylthio)Phenyl)-2-Morpholinopropanone-1
4) 2,2-Dimethoxy-1,2-Diphenylethan-1-one

Darüber hinaus können folgende Komponenten für den Aufbau der photoempfindlichen Lackschicht verwendet werden:

### Monomere:

t-butyl acrylate und methacrylate
1,5-pentanediol diacrylate und dimethacrylate
N,N-diethylaminoethyl acrylate und methacrylate
ethylene glycol diacrylate und dimethacrylate
1,4-butanediol diacrylate und dimethacrylate
dietylene glycol diacrylate und dimethacrylate
hexamethylene glycol diacrylate und dimethacrylate
1,3 - propanediol diacrylate und dimethacrylate
decamethylene glycol diacrylate und dimathacrylate
1,4 - cyclohexane diol diacrylate und dimethacrylate
2,2-dimethylolpropane diacrylate und dimethacrylate
glycerol diacrylate und dimethacrylate
tripropylene glycol diacrylate und dimethacrylate
glycerol triacrylate und trimethacrylate
trimethylolpropane triacrylate und trimethacrylate
pentaerythritol triacrylate und trimethacrylate
polyoxyethylated trimethylolpropane triacrylate und trimethacrylate
2,2-di(p-hydroxyphenyl)-propane diacrylate
pentaerythritol tetraacrylate und tetramethecrylate
2,2-di(p-hydroxyphenyl)-propane dimethylacrylate
triethylene glycol diacrylate
polyoxyethyl-2,2-di(p-hydroxyphenyl)-propane dimethylacrylate
di-(3-methacryloxy-2-hydroxy propyl) ether von bisphenol-A
di-(2-methacryloxyethyl) ether von bisphenol-A
di-(3-acryloxy-2-hydroxypropyl) ether von bisphenol-A
di-(3-methacryloxy-2-hydroxypropyl) ether von bisphenol-A
triethylene glycol dimethacrylate
polyoxypropyltrimethylol propane triecrylate
butylene glycol diacrylate und dimethacrylate
1,2,4-butanetriol triacrylate und trimethacrylate
2,2,4-trimehtyl-1,3pentanediol diacrylate und dimethacrylate
1-phenyl ethylene-1,2-dimethylacrylate
diallyl fumarate
styrene
1,4-benzenediol dimethylacrylate
1,4-diisopropenyl benzene
1,3,5-triisopropenyl benzene

### Besonders bevorzugte Monomere sind:

ethoxylated trimethylolpropane triacrylate
ethylated pentaerythritol triacrylate
dipentaerythritol monohydroxypentacrylate
1,10-decanediol dimathylacrylate
di-(3-acryloxy-2-hydroxypropyl) ether von bisphenol A oligomeren
di-(3-methecryloxy-2-hydroxyl alkyl) ether von bisphenol A oligomeren
urethane diacrylates und methacrylates und oligomere hiervon
caprolactone acrylates und methacrylates
propoxylated neopentyl glycol diacrylate und methacrylate und
Mischungen hiervon

### Verwendet werden können als Photoinitiatoren:

vicinal ketaldonyl alcohols (benzoin, pivaloin)
acyloin ethers (benzoin methyl ether, benzoin ethyl ether)
benzil dimethyl ketal
a-hydrocarbon-substitierte aromatische acyloins
a-methyl-benzoin
a-allyl-benzoin
a-phenyl-benzoin
1-hydroxyl cyclohexyl phenol keton
diethoxyphenyl aceto-phanone
2-methyl-1-|4-(methylthio)phenyl|-2-morpholino-propanone-1
benzophenone
acryloxy benzophenon
a-methoxybenzophenone
2,4,5-triphenylimidazolyl dimers mit Wasserstoffspendern
Farbstoffe der phenazine -, oxazine - und quinone - Klasse
Michler's Keton
methyl-ethylketone
anthraquinone
9,10-anthraquinone
2 methylanthraquinone
2-ethylanthraquinone
2-tert-butylanthraquinone
octamethylanthraquinone
1,4-naphthoquinone
9,10-phenanthraquinone
benz(a)anthracene-7,12-dione
2,3-naphtacene-5,12-dione
2-methyl-1,4-naphtoquinone
1,4-dimethylanthraquinone
2-phenylanthraquinone
acenaphtenaquinone
2,3-diphenyl-anthraquinone
retenequinone
7,8,9,10-tetrahydronaphtacene-5,12-dione
1,2,3,4-tetrahydrobenz(a)anthracene-7,12-dione
alpha-amino aromatische Ketone
trichlormethyl-substituierte cyclohexadienone
triazine
acetophenone
chlorierte Acetophenone

Im nächsten Verfahrensschritt wird die photoempfindliche Lackschicht möglichst vollständig getrocknet, d. h. es wird das Lösungsmittel abgedampft, welches aus verfahrenstechnischen Gründen in das Photopolymer eingebracht werden mußte. Hierzu werden die schon während des Beschichtungsvorgangs luftvorgetrockneten Schablonen in einem Warmluftofen nachgetrocknet, so daß keine Lösungsmittelreste in der Schicht mehr verbleiben. Gleichzeitig werden wichtige Eigenschaften durch diese Trocknung herbeigeführt oder zumindest beeinflußt. Die Haftung der photoempfindlichen Lackschicht am metallischen Untergrund, also am Rundsieb 1, wird durch höhere Temperaturen verbessert, während aber gleichzeitig das optische Auflösungsvermögen verringert wird. Die Trocknung wird daher bei Temperaturen zwischen 60°C und 150°C durchgeführt und muß, um die genannten Eigenschaften gleichmäßig zu erhalten, sehr sorgfältig in Bezug auf Zeit und Temperatur ausgeführt werden. Bei Lackschichten, die für die endgültige Vernetzung ein Monomer erfordern, ist während des Trocknungsvorgangs darauf Rücksicht zu nehmen, daß dieses nicht oder nur zu einem sehr geringen Teil abdampfen darf. In diesem Fall wird das Photopolymer natürlich flüssig bleiben, was eine klebrige Oberfläche der Lackschicht zur Folge hat. Die Viskosität dieser Schicht wird aber durch Abdampfen der Verdünner sehr groß eingestellt, und darüber hinaus kann die Schicht in ihrer rheologischen Eigenschaft durch geeignete Additive bzw. Füllstoffe thixotrop eingestellt werden, so daß die noch unvernetzte Polymerschicht nicht abfließen kann.

Je nach der Beschaffenheit der Polymerschicht wird die Trocknung nun entweder so erfolgen, daß man das Rundsieb 1 in denTrockenofen stellt, d. h. daß die Achse 9 des Rundsiebes 1 vertikal verläuft, oder man wird bei niedrigerer Viskosität der Lackschicht das Rundsieb 1 auf horizontale Dorne aufschieben und diese ggf. sogar in Drehung versetzen, so daß ein Abfließen der Polymerschicht am Beginn des Trocknungsprozesses verhindert wird.

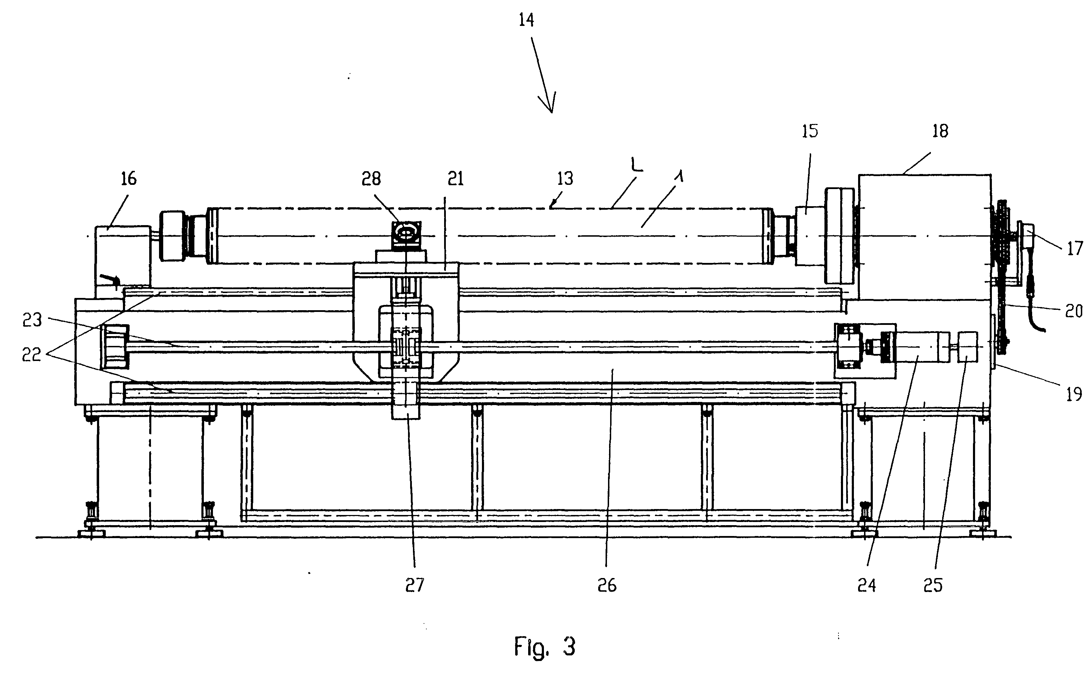

Anhand der Figuren 3 bis 6 wird der nachfolgende Verfahrensschritt der Belichtung mit Hilfe eines Lasers beschrieben. Durch diesen Laser wird die zu vernetzende Photopolymerschicht punktweise an den musterbedingt zu vernetzenden Stellen belichtet und damit verfestigt. Diese Stellen bleiben später nach der Entwicklung der Photopolymerschicht stehen.

Eine Rundform 13, darunter versteht man entweder das mit Photopolymer beschichtete Rundsieb 1 oder das auf ein Trägerrohr aufgezogene und ebenfalls mit Photopolymer beschichtete Flachsieb, wird in eine Rotationsbelichtungsmaschine 14 zwischen ein Spannfutter 15 und einen Reitstock 16 eingelegt. Durch das Schließen des Spannfutters 15 wird mit der Rundform 13 ein Drehlagenencoder 17 drehsteif verbunden. Letzterer ist auf der rechten Seite eines Spindelstocks 18 der Rotationsbelichtungsmaschine 14 angeordnet. Der rotatorische Antrieb der Rundform 13 und der mit dieser verbundenen Anlagenteile erfolgt durch einen Hauptantriebsmotor 19 über einen schwingungsgedämpften Keilriementrieb 20. Während sich die Rundform 13 dreht, wird ein Optikschlitten 21 entlang von Führungen 22 mit Hilfe einer Vorschubspindel 23 und einem mit dieser gekuppelten Schrittmotor 24 bewegt. Am rechten Wellenende des Schrittmotors 24 wird ein Drehschwingungsdämpfer 25 aufgesetzt. Die Führungen 22 und die Vorschubspindel 23 sind an einem Führungsbett 26 der Rotationsbelichtungsmaschine 14 gelagert.

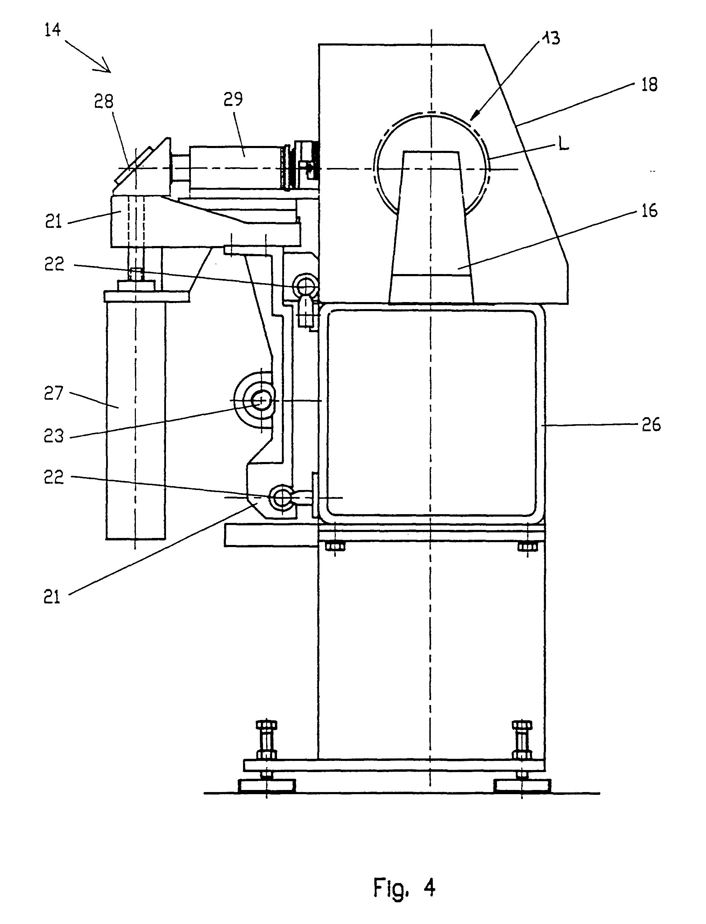

In den Figuren 3 und 4 ist ein mit dem Optikschlitten 21 mitgeführter Argonlaser 27 vorhanden, dessen Laserstrahl über einen Umlenkspiegel 28 aus der ursprünglich vertikalen Richtung in eine horizontale Richtung umgelenkt wird, so daß er dann über eine UV-Optik 29 radial auf die Oberfläche der Rundform 13 fokussiert wird.

Zur Stabilisierung der Schablonenwandung in radialer und tangentialer Richtung können Führungselemente (Rollen, Gleitführungen) vorgesehen werden, jedoch ist dies natürlich nur bei solchen Photopolymeren möglich, welche schon im nicht vernetzten Zustand eine trockene, d. h. feste Oberfläche aufweisen.

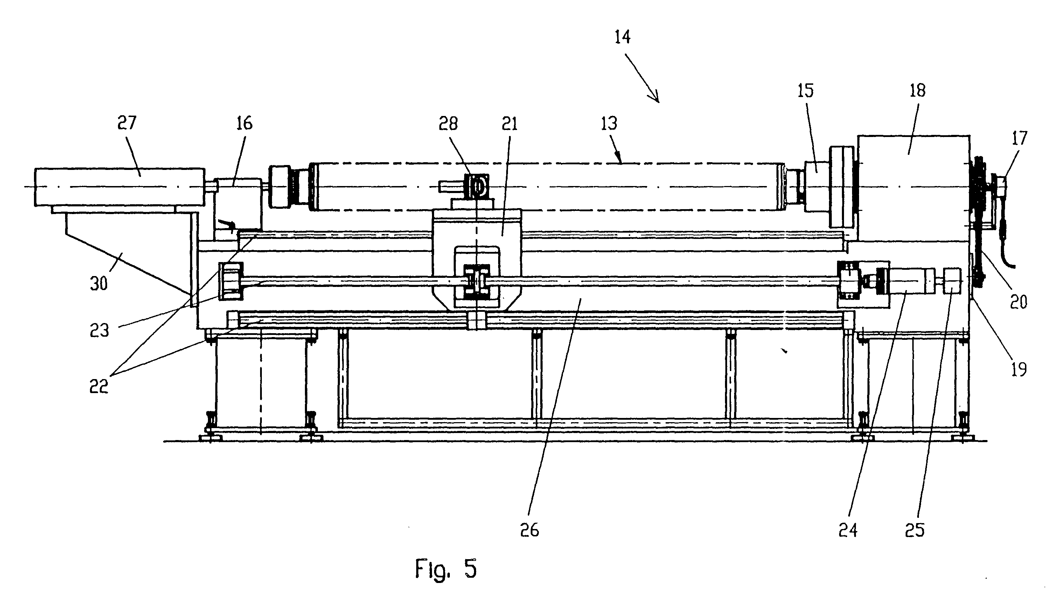

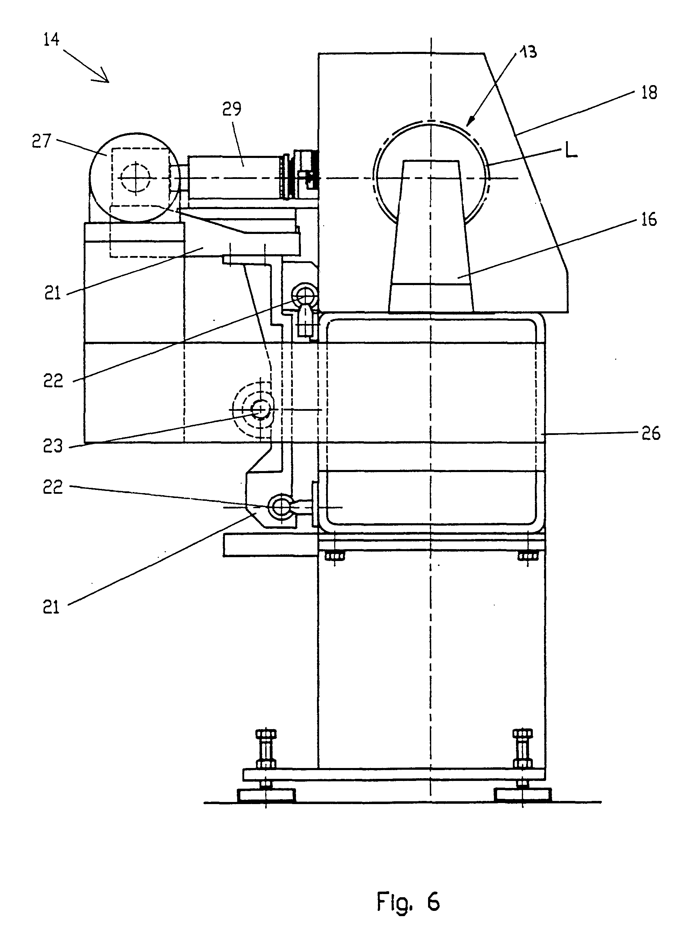

In den Figuren 5 und 6 ist ein ortsfester Argonlaser 27 dargestellt, welcher am reitstockseitigen Ende der Rotationsbelichtungsmaschine 14 über eine Konsole 30 angebracht ist. Anstelle des Argonlasers kann natürlich auch ein anderer im Bereich von 200 bis 400 nm emittierender UV-Laser Verwendung finden, beispielsweise ein Edelgas-Ionen-Laser, ein Farbstoff- oder Excimerenlaser, ein Stickstofflaser, und dergleichen.

Zum Zwecke der punktweisen Belichtung der Oberfläche der Rundform 13 im Fokuspunkt der UV-Optik 29 wird die Laserstrahlung z. B. über einen akustooptischen Modulator ein- oder ausgeschaltet. Für die hier benötigten Zwecke wird man vorzugsweise Quarzglas als Wechselwirkungs- oder Schaltmedium benutzen, da dieses für Licht ab der Wellenlänge von 200 nm durchlässig ist und auch eine ausreichend hohe Schallgeschwindigkeit aufweist, welche für ein hinreichend schnelles Durchschalten des Modulators erforderlich ist. Obwohl am zweckmäßigsten der Strahl 1. Ordnung Verwendung finden wird, also der an den Verdichtungszonen im Wechselwirkungsmedium reflektierte Strahl, weil dadurch ein 0 : 100 - Tastverhältnis der Strahlleistung erreicht werden kann, ist es durchaus aber auch vorstellbar, den Strahl 0. Ordnung für die Oberflächenbelichtung der Rundform 13 heranzuziehen und die dadurch verursachte teilweise Vorvernetzung an den Stellen, die unbelichtet bleiben sollen, in Kauf zu nehmen. Der Entwicklungsprozeß für die Photopolymere, der im wesentlichen in einem Herauslösen der unvernetzten Polymere aus dem Oberflächenfilm besteht, ist durchaus auch in der Lage, teilweise vernetzte Stellen aufzulösen.

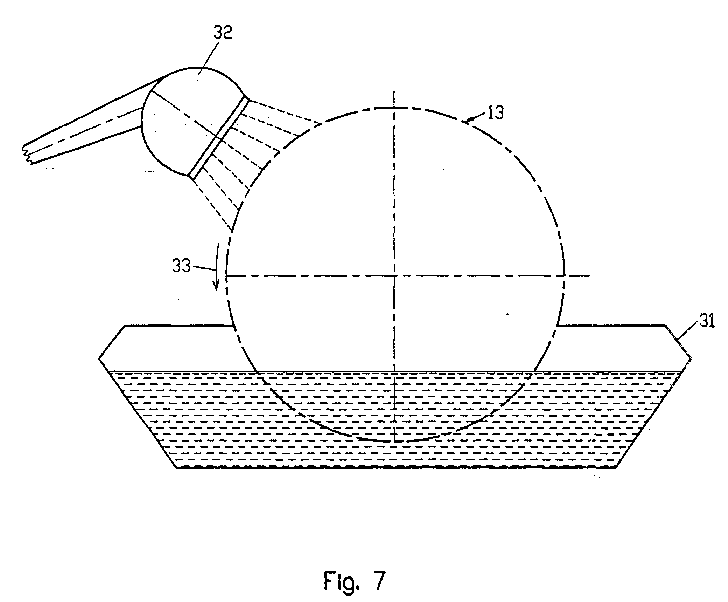

Der letzte Verfahrensschritt, der soeben auch angesprochen wurde, ist in Abbildung 7 schematisch dargestellt. Die Rundform 13 wird in ein Entwicklermedium getaucht, welches sich in einer Wanne 31 befindet und es werden dadurch die nicht durch die Lichteinwirkung vernetzten Stellen aus der aus dem Rundsieb 1 liegenden Photopolymerschicht herausgelöst. Zwecksmäßigerweise kann die Entwicklerflüssigkeit aus einer alkalischen Lösung (Soda, Kalilauge, Natronlauge) bestehen. Zur Unterstützung des Entwicklungsvorgangs kann unverbrauchte Entwicklerlösung aus einer Brause 32 auf die Oberfläche der Rundform 13 aufgesprüht werden. Die Rundform läuft während des Entwicklungsvorgangs im Sinne der Pfeilrichtung 33 um.

## Patentansprüche

1. Verfahren zur Herstellung einer Siebdruckschablone, insbesondere zum Bedrucken von Textilien, mit folgenden Schritten:
**a)** Bildung eines hohlzylindrischen Rundsiebs (1);
**b)** Auftragen einer photoempfindlichen Lackschicht (L) auf die äußere Oberfläche des Rundsiebs (1), die durch geeignete Additive bzw. Füllstoffe thixotrop eingestellt ist, so daß die noch unvernetzte Lackschicht (L) nicht abfließen kann;
**c)** die schon während des Beschichtungsvorgangs luftvorgetrocknete Schablone wird in einem Warmluftofen nachgetrocknet, so daß keine Lösungsmittelreste mehr in der Lackschicht (L) verbleiben;
**d)** ortsselektives Belichten der Lackschicht (L) mittels einer Lasereinrichtung (27) zwecks Vernetzung und Aushärtung der belichteten Stellen der Lackschicht (L) unter Drehung des Rundsiebs (1); und
**e)** Entwickeln der so belichteten Lackschicht (L).

2. Verfahren nach Anspruch 1, **dadurch gekennzeichnet, daß** zur Bildung des Rundsiebes (1) ein Flachsieb auf ein dünnes, kreisrundes Hohlprofilrohr aufgelegt wird.

3. Verfahren nach Anspruch 1 oder 2, **dadurch gekennzeichnet, daß** das Auftragen der photoempfindlichen Lackschicht (L) mittels einer Ringrakel (2) erfolgt.

4. Verfahren nach Anspruch 1 oder 2, **dadurch gekennzeichnet, daß** das Auftragen der photoempfindlichen Lackschicht (L) durch Aufsprühen von Lack mittels einer Zerstäuberdüse (8) unter Drehung des Rundsiebes (1) erfolgt.

5. Verfahren nach einem der Ansprüche 1 bis 4, **dadurch gekennzeichnet, daß** zur Bildung der photoempfindlichen Lackschicht (L) ein einen Photoinitiator enthaltendes Monomer aufgetragen wird.

6. Verfahren nach Anspruch 5, **dadurch gekennzeichnet, daß** das Monomer Urethan Diacrylate und/oder Methacrylate enthält.

7. Verfahren nach Anspruch 5 oder 6, **dadurch gekennzeichnet, daß** das Monomer als Photoinitiator 1 bis 4 Gew.% an 2-Benzyl-2-Dimethylamino-1-(4-Morpholinophenyl)-Butanone-1, ggf. gemischt mit 1 bis 3 Gew.% an 1-Hydroxy-Cyclohexal-Phenyl-Keton, enthält.

8. Verfahren nach Anspruch 5 oder 6, **dadurch gekennzeichnet, daß** als Photoinitiator 2-Hydroxy-2-Methyl-1-Phenyl-Propan-1-one verwendet wird.

9. Verfahren nach Anspruch 5 oder 6, **dadurch gekennzeichnet, daß** als Photoinitiator eine Mischung aus 1-Hydroxy-Cyclohexyl-Phenyl-Keton und Benzophenon verwendet wird.

10. Verfahren nach Anspruch 5 oder 6, **dadurch gekennzeichnet, daß** als Photoinitiator 2-Methyl-1-(4-(Methylthio)Phenyl)-2-Morpholinopropanone-1 verwendet wird.

11. Verfahren nach Anspruch 5 oder 6, **dadurch gekennzeichnet, daß** als Photoinitiator 2,2-Dimethoxy-1,2-Diphenylethan-1-one verwendet wird.

12. Verfahren nach Anspruch 1, **dadurch gekennzeichnet, daß** das Rundsieb (1) zum Trocknen der Lackschicht (L) mit seiner Längsachse vertikal aufgestellt wird.

13. Verfahren nach Anspruch 1, **dadurch gekennzeichnet, daß** das Rundsieb (1) beim Trocknen der Lackschicht (L) horizontal liegt und um seine Längsachse gedreht wird.

14. Verfahren nach Anspruch 12, 13, **dadurch gekennzeichnet, daß** das Trocknen der Lackschicht (L) bei Temperaturen im Bereich von 60°C bis 150°C erfolgt.

15. Verfahren nach einem der Ansprüche 1 bis 14, **dadurch gekennzeichnet, daß** die Belichtung der Lacksicht (L) mit UV-Strahlung erfolgt.

16. Verfahren nach Anspruch 15, **dadurch gekennzeichnet, daß** die Wellenlänge der UV-Strahlung im Bereich von 200 nm bis 450 nm liegt.

17. Verfahren nach einem der Ansprüche 1 bis 16, **dadurch gekennzeichnet, daß** die Lackschicht (L) unter Verwendung einer alkalischen Lösung entwickelt wird.

18. Verfahren nach einem der Ansprüche 1 bis 17, **dadurch gekenn** zeichnet, daß das Rundsieb (1) in eine Rotationsvorrichtung (14) eingespannt wird, und daß die Lackschicht (L) anschließend unter Drehung des Rundsiebes (1) in aufeinanderfolgenden Schritten aufgebracht, getrocknet, belichtet und entwickelt wird.

## Claims

1. Process for manufacturing a screen printing stencil, especially for printing textiles, comprising the following steps:
**a)** forming a hollow-cylindrical round screen (1);
**b)** applying a photosensitive coating layer (L) to the round screen (1) outer surface which has been rendered thixotropic by means of suitable additives or fillers, so that the coating layer (L) not yet crosslinked cannot run off;
**c)** the stencil, which has been air-predried even during the coating operation, is postdried in a warm-air oven, so that no residual solvent will remain in the coating layer (L);
**d)** location-selective exposure of the coating layer (L) by means of a laser device (27) for the purpose of cross-linking and curing the exposed positions of the coating layer (L) while rotating the round screen (1); and
**e)** developing the coating layer (L) thus exposed.

2. Process according to Claim 1, **characterized in that** in order to form the round screen (1), a flat screen is placed onto a thin, circular hollow-section pipe.

3. Process according to Claim 1 or 2, **characterized in that** the photosensitive coating layer (L) is applied by means of a doctor ring (2).

4. Process according to Claim 1 or 2, **characterized in that** the photosensitive coating layer (L) is applied by spraying on the coating by means of an atomizing nozzle (8) while rotating the round screen (1).

5. Process according to one of Claims 1 to 4, **characterized in that,** in order to form the photosensitive coating layer (L), a monomer containing a photoinitiator is applied.

6. Process according to Claim 5, **characterized in that** the monomer contains urethane diacrylates and/or methacrylates.

7. Process according to Claim 5 or 6, **characterized in that** the monomer contains, as a photoinitiator, from 1 to 4% by weight of 2-benzyl-2-dimethylamino-1-(4-morpholinophenyl)butan-1-one, optionally mixed with from 1 to 3% by weight of 1-hydroxycyclohexyl phenyl ketone.

8. Process according to Claim 5 or 6, **characterized in that** the photoinitiator used is 2-hydroxy-2-methyl-1-phenylpropan-1-one.

9. Process according to Claim 5 or 6, **characterized in that** the photoinitiator used is a mixture of 1-hydroxycyclohexyl phenyl ketone and benzophenone.

10. Process according to Claim 5 or 6, **characterized in that** the photoinitiator used is 2-methyl-1-(4-(methylthio)phenyl)-2-morpholinopropan-1-one.

11. Process according to Claim 5 or 6, **characterized in that** the photoinitiator used is 2,2-dimethoxy-1,2-diphenylethan-1-one.

12. Process according to Claim 1, **characterized in that** the round screen (1), for the purpose of drying the coating layer (L) is positioned so that its longitudinal axis is vertical.

13. Process according to Claim 1, **characterized in that** the round screen (1), while the coating layer (L) is drying, is positioned horizontally and is rotated about its longitudinal axis.

14. Process according to Claim 12, 13, **characterized in that** drying of the coating layer (L) is carried out at temperatures in the range from 60°C to 150°C.

15. Process according to any one of Claims 1 to 14, **characterized in that** the exposure of the coating layer (L) is carried out using UV radiation.

16. Process according to Claim 15, **characterized in that** the wavelength of the UV radiation is in the range from 200 nm to 450 nm.

17. Process according to any one of Claims 1 to 16, **characterized in that** the coating layer (L) is developed by employing an alkaline solution.

18. Process according to any one of Claims 1 to 17, **characterized in that** the round screen (1) is clamped in a rotary appliance (14) and that the coating layer (L), while the round screen (1) is rotated, in successive steps is then applied, dried, exposed and developed.

## Revendications

1. Procédé de fabrication d'un écran de sérigraphie, en particulier pour l'impression sur textiles, comportant les étapes suivantes :
a) Formation d'un écran rond (1) présentant un creux cylindrique ;
b) Application d'une couche de laque photosensible (L) sur la surface extérieure de l'écran rond (1), qui a été réglée avec des additifs ou charges appropriés, pour avoir un comportement thixotropique, de manière à ce que la couche de laque(L)encore non réticulée ne puisse pas s'écouler ;
c) Séchage dans un four à circulation d'air chaud de l'écran rond déjà séché préalablement à l'air pendant l'opération d'application, de manière à ce qu'il ne reste plus aucun résidu de solvant dans la couche de laque (L) ;
d) Exposition sélective localisée de la couche de laque (L) à l'aide d'un dispositif à laser (27) afin d'obtenir une réticulation et un durcissement des régions exposées de la couche de laque (L)en faisant tourner l'écran rond (1) ; et
e) Développement de la couche de laque (L) ainsi exposée.

2. Procédé selon la revendication 1 **caractérisé en ce que**, pour la formation de l'écran rond (1) on applique un écran plan sur un mince tube profilé creux circulaire.

3. Procédé selon la revendication 1 ou 2 **caractérisé en ce que** l'application de la couche de laque (L) photosensible est effectuée à l'aide d'une râcle annulaire (2).

4. Procédé selon la revendication 1 ou 2, **caractérisé en ce que** l'application de la couche de laque photosensible (L) est effectuée par pulvérisation de la laque au moyen d'une buse de pulvérisation (8) tout en faisant tourner l'écran rond (1).

5. Procédé selon l'une quelconque des revendications 1 à 4, **caractérisé en ce que**, pour former la couche de laque photosensible (L), on applique une couche de monomère renfermant un photo-initiateur.

6. Procédé selon la revendication 5, **caractérisé en ce que** le monomère renferme de l'uréthane diacrylate et méthacrylate.

7. Procédé selon la revendication 5 ou 6 **caractérisé en ce que** le monomère renferme, en tant que photo-initiateur, 1 à 4% en poids d'un 2-benzyle-2 diméthylamino-1-(4 morpholinophényl)-butanone-1, éventuellement en mélange avec 1 à 3% en poids d'une 1-hydroxy-cyclohexal-phenyl-cétone.

8. Procédé selon la revendication 5 ou 6, **caractérisé en ce que** en tant que photo-initiateur, on utilise la 2-hydroxy-2-methyl-1-phenyl-propan-1-one.

9. Procédé selon la revendication 5 ou 6, **caractérisé en ce que**, en tant que photo-initiateur, on utilise un mélange de 1-hydroxy-cyclohexyl-phenyl-cétone et de benzophénone.

10. Procédé selon la revendication 5 ou 6, **caractérisé en ce que**, en tant que photo-initiateur on utilise de la 2-methyl-1-(4-(methylthiophényl)-2-morpholino-propanone-1.

11. Procédé selon la revendication 5 ou 6, **caractérisé en ce que**, en tant que photo-initiateur, on utilise de la 2,2 dimethoxy-1,2 diphényléthane-1- one.

12. Procédé selon la revendication 1, **caractérisé en ce que**, pour le séchage de la couche de laque (L), l'écran rond (1) est disposé avec son axe long en position verticale.

13. Procédé selon la revendication 1 **caractérisé en ce que** l'écran rond (1) se trouve, pendant le séchage de la couche de laque (L), en position horizontale et est tourné autour de son axe longitudinal.

14. Procédé selon la revendication 12 ou 13, **caractérisé en ce que** l'on effectue le séchage de la couche de laque (L) dans la fourchette de température de 60° C à 150°C.

15. Procédé selon l'une quelconque des revendications 1 à 14, **caractérisé en ce que** l'exposition de la couche de laque (L) est effectuée à l'aide d'un rayonnement UV.

16. Procédé selon la revendication 15 **caractérisé en ce que** la longueur d'onde du rayonnement UV se trouve dans le domaine de 200 à 450 nanomètres.

17. Procédé selon une quelconque des revendications 1 à 16 **caractérisé en ce que** la couche de laque(L)est développée en utilisant une solution alcaline.

18. Procédé selon une quelconque des revendications 1 à 17, **caractérisé en ce que** l'écran rond (1) est intégré dans un dispositif tournant (14) et que la couche de laque (L) est ensuite successivement appliquée, séchée, exposée et développée en tournant l'écran rond (1).
